# EUROPEAN PATENT SPECIFICATION

(11) **EP 1 746 178 B1**
(45) Date of publication and mention of the grant of the patent: **07.08.2013**
(21) Application number: 06445051.3
(22) Date of filing: 20.06.2006
(51) Int. Cl.: C23C 14/02, C23C 14/35, H01J 37/34

(54) **Device for improving plasma activity in PVD-reactors**
Vorrichtung zur Verbesserung der Plasma-Wirksamkeit in PVD-Reaktoren
Dispositf pour l'amélioration de l'activité du plasma dans les réacteurs PVD

(30) Priority: 22.07.2005 SE 0501717
(43) Date of publication of application: 24.01.2007
(73) Proprietor: Sandvik Intellectual Property AB, 811 81 Sandviken (SE)
(72) Inventor: Myrtveit, Toril, 196 30 Kungsängen (SE); Rodmar, Markus, Vallentuna (SE); Selinder, Torbjörn, 117 61 Stockholm (SE)
(74) Representative: Taquist, Henrik Lennart Emanuel

(56) References cited:
- US-A- 5 294 322
- US-A- 5 840 167
- US-A- 6 153 061
- US-A1- 2003 143 868
- US-A1- 2005 034 667
- CHINN J D: "ION BEAM ENHANCED MAGNETRON REACTIVE ION ETCHING" APPLIED PHYSICS LETTERS, AIP, AMERICAN INSTITUTE OF PHYSICS, MELVILLE, NY, US, vol. 51, no. 24, 14 December 1987 (1987-12-14), pages 2007-2009, XP000046333 ISSN: 0003-6951

## Description

The present invention relates to a device for achieving an enhanced plasma activity in PVD reactors. Due to the increased plasma density the invention enables operation of sputter etching at much lower pressure than otherwise possible in a magnetron sputtering PVD coating chamber. Thus, gas phase scattering is avoided and problems with redeposition and contamination of sputter cleaned surfaces of 3-D objects are eliminated. The invention allows for sputter etching substrates in a magnetron sputtering system at bias values suitable to avoid impact damage.

Modern high productivity chip forming machining of metals requires reliable tool inserts with high wear resistance, good toughness properties and excellent resistance to plastic deformation.

This has so far been achieved by employing cemented carbide inserts coated with wear resistant layers like TiN, TiₓAl_{y}N, CrₓAl_{y}N and Al₂O₃. Such layers have been commercially available for many years. Several hard layers in a multilayer structure generally build up a coating. The sequence and the thickness of the individual layers are carefully chosen to suit different cutting application areas and work-piece materials.

The coatings are most frequently deposited by Chemical Vapour Deposition (CVD), Moderate Temperature CVD (MTCVD) or Physical Vapour Deposition (PVD) techniques.

CVD layers are generally deposited at a temperature between 900 and 1000 °C and MTCVD at 700-800 °C using acetonitril, CH₃CN, as a reactant. The advantages of CVD are good adhesion, relatively thick layers can be grown and the possibility to deposit insulating layers like Al₂O₃.

PVD refers to a number of methods in which a metal vapour is provided in a suitable atmosphere to form the desired compound to be deposited by thermal evaporation, sputtering, ion plating, arc evaporation etc. at a temperature of 100-700 °C. With PVD, many more materials can be deposited than in CVD, and the layers have compressive stress as opposed to tensile stress in CVD-layers. The low deposition temperature on the other hand causes problems with the adhesion of the layers. For that reason coating of substrates with PVD-technology usually involves several cleaning steps.

The substrates are generally pre-treated before entering the PVD reactor using, e.g., blasting, wet etching and/or cleaning in solvents. Immediately preceding deposition, an in vucuo sputter-etching step is most often included to further clean the substrates from moisture, native oxides and other impurities not removed during the pretreatment step. The etching step is generally performed by providing a plasma at a pressure in the range of 0.2-1.0 Pa in the reactor. By applying a negative bias to the substrates, ions from this plasma bombard the substrates and thus clean the surfaces thereof. The bias should be high enough to sputter etch the substrates, but not high enough to damage the surface. Typical bias values are approximately -200 V, whereas values below -500 V start to cause radiation damage by ion impact. The plasma is commonly generated by an electrical discharge in a rare gas atmosphere, e.g., Ar, inside the PVD reactor. A low plasma activity in this step may lead to incomplete etching, anisotropic etching and/or redeposition of sputtered material. More redeposition entails the higher the Ar pressure during etching. This is due to the fact that as the mean free path of gas molecules shrinks the probability of gas phase scattering increases and hence a cloud of etched material is likely to redeposit and contaminate the surface all over again. Redeposition and anisotropic etching is especially a concern when working with three-dimensional structures where parts thereof will be 'shadowed' from the plasma; that is, surfaces that do not have the main plasma in direct line-of-sight.

Sputter-etching can be achieved in a number of different ways. One possibility is to ignite plasma in an Ar atmosphere using a hot W filament, as disclosed in GB-A-2049560or US 615 3061. Other, more chemically reactive gases, e.g., H₂ and fluorocarbons, can also be present to enhance the process. The thermionic filament should be protected from the plasma as it will otherwise also be etched. This is achieved by placing the filament in a separate filament chamber. The electrons must in this case be accelerated out of this chamber by an anode situated in the opposite part of the etching chamber. The electrons that traverse the chamber ionize the Ar gas which plasma is homogeneously distributed and may be used to sputter etch the substrates. The electron channel throughout the height of the chamber must be diverged radially using large magnetic coils located on the top and the bottom of the reactor. The technology is quite complicated and demands a high degree of control in order to distribute the plasma evenly over the substrates. One advantage of the above method is that the etching may be conduced at low pressures, approximately 0.2 Pa, which reduces redeposition problems.

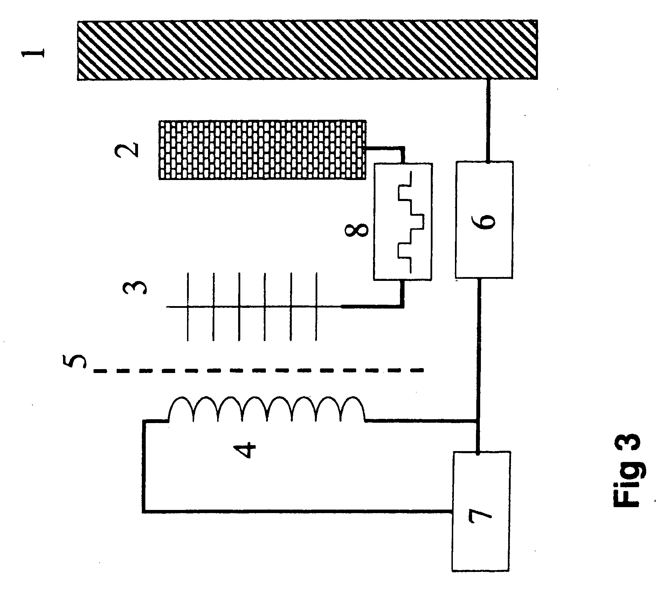

An elegant alternative way of creating homogenous sputter-etching plasma without rigorous controls is to apply an alternating voltage between substrates and a counter electrode, as disclosed in WO 97/22988. The counter electrode can be a magnetron source used also in the deposition process, which follows the etching process. The electrical connections are schematically shown in Figure 3 together with the present invention. The prior art consists of the circuit made by the substrates (3), the power supply (8), and the magnetron source (2). This method works fairly well at pressures above 0.8 Pa, but unfortunately at this high pressure redeposition of etched material is often seen on truly 3-dimensional substrates. The high pressure needed for operation, generating the etching plasma is due to the low degree of ionization seen in magnetron sputtering technology. In addition, valuable sputter material is unfortunately used for sputter cleaning.

In US 5,294,322 it is taught how an arc discharge covered by a shutter may be used as a low voltage electron source. Again the electrons are collected at an anode. As the electrons traverse the coating chamber ions of a rare gas are generated by electron-atom impact and a separate power supply is used to accelerate these ions towards the substrates. The drawback is that either a separate dedicated arc source must be used for the electron generation, which steals valuable chamber wall space, or a shuttered deposition source may be used in which case valuable coating material is lost in the sputter etch cleaning step.

It is thus an object of the present invention to provide a device and a method for increasing the plasma intensity during sputter-etching of substrates while keeping the technology simple.

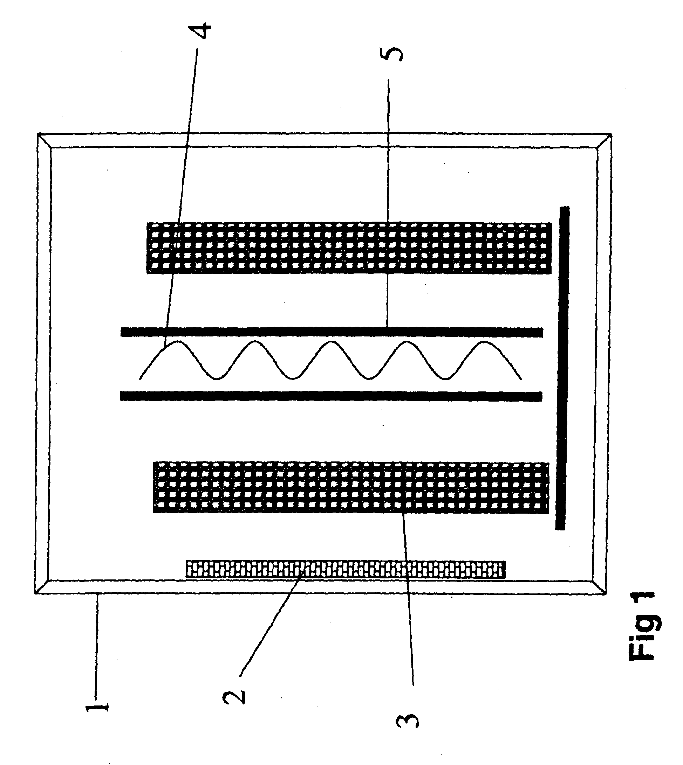

The Figures are schematic representations of the magnetron deposition system according to the invention in side view (Figure 1), top view (Figure 2), and the electrical connections according to one representation of the invention (Figure 3) in which
1 - Reactor wall
2 - Magnetron
3 - Substrates to be coated
4 - Filament
5 - Cage
6 - Power supply to accelerate electrons out from the hot filament
7 - Power supply connected to the hot filament
8 - Power supply to create the primary plasma

The present invention thus relates to a device for improving plasma activity in a PVD reactor containing substrates to be coated as defined in claim 1. According to the present invention a primary plasma is ignited by applying an alternating or direct voltage between the substrates and an additional electrode. This electrode can be at least one separate dedicated electrode, the reactor wall, at least one PVD-deposition source, magnetron and/or arc source, or preferably at least one magnetron pair or a dual magnetron sputtering (DMS) pair. The DMS technology consists of two magnetron sputtering sources connected to a bipolar pulsed power supply. To increase the plasma activity by thermionic emission of electrons, a hot filament is installed in the reactor, preferably centrally along the symmetry-axis and extending from top to bottom of the reactor. With filament is meant any adequate design such as thread, mesh, band or similar. The filament is preferably helix-wound or otherwise constructed to allow for thermal expansion/shrinkage. The filament is preferably made from efficient electron-emitting material such as W, thoriated W or a coated filament, where the coating is an efficient electron emitter such as rare earth oxides, carbon nanotubes, barium oxides etc. The filament can be in the form of one long filament or as several shorter filaments connected either in series or in parallel or combinations thereof. Either DC or AC current or combinations thereof can be used for heating the filament. The filament preferably is situated in the centre of the reactor and the electrons are evenly distributed in the z-direction (height-axis) of the reactor. To ensure effective emission of electrons from the filament as well as a good radial distribution, a DC or bipolar voltage can be applied between the filament as a cathode and a corresponding anode. This anode can be the reactor wall, one or more separate electrodes, or one or more of the electrodes used for creating the primary plasma. The electrons generate plasma as they traverse the separating space between the cathode filament and the anode, giving rise to Ar ionization in the process. This enhanced plasma density enables sputter etching at much lower pressure in the range of 0.1-0.2 Pa than otherwise possible in a magnetron deposition system. The increased ionization enables operation of sputter etching at substrate bias values around -200 V, giving less ion impact damage than by prior art technology for magnetron sputtering systems.

The filament is exposed to the plasma and thus erodes with time. Due to this, the filament must either be replaced on a routine basis, or protected by a cage comprising of, e.g., a metal cylinder, a mesh, or metal rods surrounding the filaments but with small slits from which the emitted electrons can be accelerated out into the plasma. The potential of the cage is in the range from the potential of the hot filament to the potential of the suitable anode.

The device according the invention is particularly useful in a magnetron sputtering system.

The invention also relates to the use of the device to enhance the plasma activity when utilized for sputter etching prior to the deposition of layers on cutting tool inserts made of cemented carbide, high speed steels, cermets, ceramics, cubic boron nitride or metals like steel, as well as coating of metal wires, rods and bands particularly cutting tool inserts made of cemented carbide, high speed steels, cermets, ceramics or cubic boron nitride.

### EXAMPLE 1 (prior art)

Sputter etching of cemented carbide cutting inserts was performed according to the system described in WO 97/22988. A plasma was ignited at a moderate pressure of 0.8 Pa and a substrate-target voltage of 800 V, which was the minimum voltage to operate the etching. A current flowing through the substrates of 2 A was achieved. This substrate current was limited by the ion density resulting from using a magnetron as counter electrode. The current was, furthermore, related to the impact by charged ions and was thus a measure of the etch. The substrates showed after this sputter-etching procedure signs of redeposition on shadowed surfaces. The voltage necessary to operate the discharge was high enough to risk impact damage to the substrates.

### EXAMPLE 2 (invention)

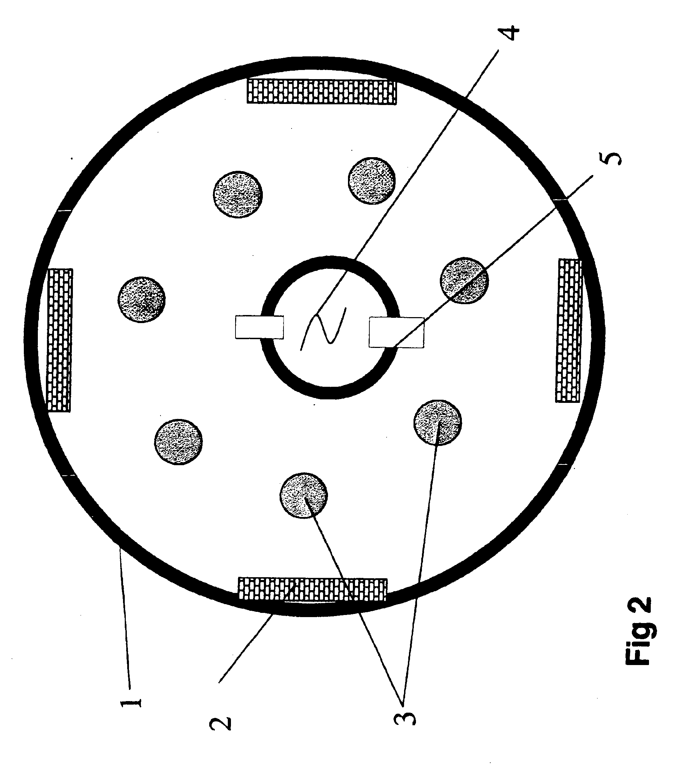

Example 1 was repeated utilizing the system as described above but with the addition of a centrally situated hot W-filament, as indicated in Figure 2. By heating the filament with 11 A and applying a voltage of 360 V between the filament (cathode) and the reactor wall (anode), etching was achieved at 0.2 Pa. With a substrate - Ti-counter electrodes (magnetron sources) voltage of 200 V, a substrate current of 7 A was measured. This voltage was not the minimum etching voltage necessary but selected as appropriate. The substrates were clearly more and deeper etched and showed no signs of redeposition, not even on highly shadowed areas.

Thus, when etching according to the present invention a more efficient etch was obtained, at a lower substrate voltage which implies less impact damage and at a lower pressure thus eliminating redeposition.

### EXAMPLE 3

The inserts from Examples 1 and 2 were, immediately following the etch, coated with a 1.6 µm thick layer of Al₂O₃ using a standard deposition process: DMS using two pairs of magnetrons equipped with Al targets. A background pressure of 0.23 Pa Ar was maintained for the sputtering gas discharges which were run at 40 kW each. Oxygen reactive gas was fed at 2 x 30 sccm and controlled by an optical emission feedback circuit. This resulted in crystalline alumina layers. The two sets of inserts were evaluated in a turning test in stainless steel, with the object to determine the adhesion of the coatings. The results indicated that the inserts etched according to prior art technology exhibited extensive flaking while the inserts etched according to the invention showed less flaking and less indications of wear.

## Claims

1. A PVD reactor comprising a device for improving plasma activity containing substrates to be coated (3), where a primary plasma is created by a DC or AC voltage applied between the substrates and at least one additional electrode, comprising a filament (4) as a thermionic emitter in the form of one long filament or as several shorter filaments connected either in series or in parallel or combinations thereof, heated by either DC or AC current or combinations thereof **characterised in that** the **hot** filament is extending from top to bottom of the reactor.

2. **A PVD reactor** according to the previous claim **characterised in that** the hot filament is the cathode of a system and the corresponding anode is one or more separate dedicated electrodes.

3. **A PVD reactor** according to claim 1 **characterised in that** the hot filament is the cathode of a system and the corresponding anode is the reactor wall.

4. **A PVD reactor** according to claim 2 or 3 **characterised in that** the corresponding anode is the at least one additional electrode used to create the primary plasma.

5. **A PVD reactor** according to any of the previous claims **characterised in that** the filament is either W, thoriated W or any coated filament where the coating is an efficient electron emitter such as rare earth oxides or carbon nanotubes.

6. A **PVD reactor** according to the any of the previous claims **characterised in that** the hot filament is protected by a chamber or a cage with small apertures from which the emitted electrons can escape with a potential in the range from the potential of the hot filament to the potential of the corresponding anode.

7. **A PVD reactor** according to the any of the previous claims **characterised in that** the PVD coating system is a magnetron sputtering system.

8. Use of the **PVD reactor comprising the** device according to any of the previous claims to achieve enhanced sputter etching prior to the deposition of layers on cutting tool inserts made of cemented carbide, high speed steels, cermets, ceramics, cubic boron nitride or metals steel, as well as coating of metal wires, rods and bands.

## Patentansprüche

1. PVD-Reaktor, welcher beschichtende (3) Substrate enthält, mit einer Einrichtung zum Verbessern der Plasmaaktivität, wobei ein Primärplasma durch eine Gleich- oder Wechselspannung erzeugt wird, die zwischen den Substraten und zumindest einer zusätzlichen Elektrode erzeugt wird, mit einem Filament (4) als Emitter thermischer Ionen in Form eines langen Filamentes oder in Form mehrerer kürzerer Filamente, die entweder in Reihe oder parallel oder in Kombinationen von Reihen und Parallelschaltung verbunden sind, welche entweder durch Gleich- oder Wechselstrom oder durch Kombinationen aus Gleich- und Wechselstrom geheizt werden, dadurch gekennzeichet, dass das heiße Filament sich von dem oberen Ende zum Boden des Reaktors erstreckt.

2. PVD-Reaktor nach dem vorstehenden Anspruch, dadurch gekenntzeichnet, dass das heiße Filament die Kathode eines Systems ist und die entsprechende Anode aus einer oder mehreren getrennten, speziell hierfür vorgesehenen Elektroden besteht.

3. PVD-Reaktor nach Anspruch 1, **dadurch gekennzeichnet, dass** das heiße Filament die Katode eines Systems ist und die entsprechende Anode die Wand des Reaktors ist.

4. PVD-Reaktor nach Anspruch 2 oder 3, **dadurch gekennzeichnet, dass** die entsprechende Anode die zumindest eine zusätzliche Elektrode list, welche verwendet wird, um das Primärplasma zu erzeugen.

5. PVD-Reaktor nach einem der vorstehenden Ansprüche, **dadurch gekennzeichnet, dass** das Filament entweder aus W, thoriumligiertem W oder irgendeinem beschichteten Filament besteht, wobei die Beschichtung ein effizienter Elektronenemitter ist, wie zum Beispiel Seltenerd-Oxide oder Kohlenstoffnanoröhrchen.

6. PVD-Reaktor nach einem der vorstehenden Ansprüche, **dadurch gekennzeichnet, dass** das heiße Filament durch eine Kammer oder einen Käfig mit kleinen Öffnungen geschützt ist, aus welchem die emittierten Elektronen mit einem Potential im Bereich von dem Potential des Eisenfilamentes bis zum Potential der entsprechenden Anode entweichen können.

7. PVD-Reaktor nach einem der vorstehenden Ansprüche, dadurch gekennzeichet, dass das PVD-Beschichtungssystem ein Magnetron-Sputter-System ist

8. Verwendung des PVD-Reaktors, welcher die Einrichtung nach einem der vorstehenden Ansprüche aufweist, für das Erzielen eines verstärkten Sputterätzens vor der Abscheidung von Schichten auf Schneidwerkzeugeinsätzen, die aus Sintercarbid, Hochgeschwindigkeitsstählen, Cermets, Keramik, kubischem Bornitrid oder Stahlmetallen hergestellt sind, ebenso wie als Beschichtung von Metalldrähten, Stangen und Bändern.

## Revendications

1. Réacteur PVD comprenant un dispositif pour améliorer l'activité de plasma, contenant des substrats à revêtir (3) où un plasma primaire est créé par une tension C.C. ou C.A. appliquée entre les substrats et au moins une électrode additionnelle, comprenant un filament (4) en tant qu'émetteur thermo-ionique sous la forme d'un filament long ou sous la forme de plusieurs filaments plus courts reliés en série ou en parallèles ou des combinaisons de ceux-ci, chauffés par un courant C.C. ou C.A. ou des combinaisons de ceux-ci **caractérisé en ce que** le filament chaud s'étend du sommet à la base du réacteur.

2. Réacteur PVD selon la revendication précédente **caractérisé en ce que** le filament chaud est la cathode d'un système et l'anode correspondante est une ou plusieurs électrodes dédiées séparées.

3. Réacteur PVD selon la revendication 1 **caractérisé en ce que** le filament chaud est la cathode d'un système et l'anode correspondante est la paroi du réacteur.

4. Réacteur PVD selon la revendication 2 ou 3 **caractérisé en ce que** l'anode correspondante est l'au moins une électrode additionnelle utilisée pour créer le plasma primaire.

5. Réacteur PVD selon l'une quelconque des revendications précédentes **caractérisé en ce que** le filament est W, W thorié ou un filament revêtu quelconque, le revêtement étant un émetteur d'électron efficace tel que des oxydes de terre rare ou des nanotubes de carbone.

6. Réacteur PVD selon l'une quelconque des revendications précédentes **caractérisé en ce que** le filament chaud est protégé par une chambre ou une cage avec des petites ouvertures par lesquelles les électrons émis peuvent s'échapper avec un potentiel dans la plage du potentiel du filament chaud au potentiel de l'anode correspondante.

7. Réacteur PVD selon l'une quelconque des revendications précédentes **caractérisé en ce que** le système de revêtement PVD est un système de pulvérisation à magnétron.

8. Utilisation du réacteur PVP comprenant le dispositif selon l'une quelconque des revendications précédentes pour améliorer la gravure par pulvérisation avant le dépôt de couches sur des plaquettes d'outil coupant constituées de carbure cémenté, d'aciers rapides, de cermets, de céramiques, d'acier à nitrure de bore cubique ou à métaux, ainsi que le revêtement de fils, tiges et bandes métalliques.
